# EUROPÄISCHE PATENTSCHRIFT

(11) **EP 2 527 850 B1**
(45) Veröffentlichungstag und Bekanntmachung des Hinweises auf die Patenterteilung: **12.09.2018**
(21) Anmeldenummer: 12003714.8
(22) Anmeldetag: 10.05.2012
(51) Int. Cl.: G01R 21/133, G01D 4/00, G01R 22/10

(54) **Spannungsabhängige Zähleinrichtung**
Voltage-dependent meter
Compteur dépendant de la tension

(30) Priorität: 21.05.2011 DE 102011102185
(43) Veröffentlichungstag der Anmeldung: 28.11.2012
(73) Patentinhaber: BOB Holding GmbH, 97332 Volkach (DE)
(72) Erfinder: Beck, Bernhard, 97332 Volkach / Dimbach (DE)
(74) Vertreter: FDST Patentanwälte

(56) Entgegenhaltungen:
- DE-A1-102009 049 644
- DE-T2- 69 505 787
- US-A- 5 059 896
- US-A- 5 627 759
- US-B1- 6 675 071
- WULLSCHLEGER P: "TARIFGERATE TARIGYR 400 KONZEPT - LOESUNGEN - AUFBAU", LANDIS UND GYR MITTEILUNGEN, LANDIS UND GYR A.G. ZUG, CH, Bd. 32, Nr. 1, 1. Januar 1985 (1985-01-01) , Seiten 4-08, XP000655052,

## Beschreibung

Die Erfindung betrifft eine Zähleinrichtung zur Erfassung des elektrischen Verbrauchs der von einem Verbraucher über ein Versorgungsnetz entnommenen elektrischen Energie und/oder zur Bestimmung der von einem Energieerzeuger in ein Versorgungsnetz abgegebenen elektrischen Energie.

Eine derartige Zähleinrichtung, die häufig auch als Strom- oder Wattstundenzähler bezeichnet wird, ist üblicherweise in jedem Haushalt vorgesehen, um die einem Versorgungsnetz entnommene elektrische Energie bzw. die entnommene elektrische Arbeit zum Zwecke der Verbrauchsabrechnung zu erfassen. Hierzu werden üblicherweise der Wirkstrom (Wechsel- oder Drehstrom) sowie die momentan anliegende Wirkspannung, nachfolgend auch als Netzspannung bezeichnet, erfasst. Durch Multiplikation von Strom (Wirkstrom) und Spannung (Wirkspannung) zur elektrischen Leitung (P = U · I) sowie anschließender zeitlicher Integration der elektrischen Leistung wird die genutzte Wirkenergie in Kilowattstunden (kWh) ermittelt.

Bei industriellen Verbrauchern mit besonders hohen Leistungsspitzen können auch Leistungszähler vorgesehen sein, die zusätzlich zur entnommenen elektrischen Energie registrieren, ob die Energie in relativ kurzer Zeit unter Anfall einer besonders hohen Leistung dem Netz entnommen wurde. Diese Leistungsspitzen belasten das Versorgungsnetz in besonderer Weise und sind entsprechend abzurechnen. Analoge Zählleinrichtungen befinden sich auch an Einspeisestellen, wie z. B. bei solaren Photovoltaik-Dachanlagen oder bei Windrädern, um die von einem solchen Energieerzeuger in ein Versorgungsnetz abgegebene elektrische Energie zu bestimmen.

Zähleinrichtungen der eingangs genannten Art sind z. B. aus der EP 0 801 836 B1 und aus der US 2009/0150100 A1 sowie aus der US 5,059,896 bekannt. In der letztgenannten Druckschrift wird ein Wattstunden-Messgerät beschrieben, welches digital konfigurierbar ist, um als ein Typ von unterschiedlichen Messgerätetypen zu arbeiten.

Weitere Zähleinrichtungen sind aus DE69505787, US6675071, US5627759 und DE102009049644 bekannt.

Im Zusammenhang mit der Energieentnahme aus dem Versorgungsnetzt und der Energieeinspeisung in das Versorgungsnetzt ist auch die Erzielung einer hinreichenden Stabilität des Versorgungsnetzes wünschenswert. Am Beispiel einer Nachtspeicherheizung kann die damit verbundene Problematik anschaulich skizziert werden. So ist die typische Nachtspeicherheizung dazu eingerichtet und vorgesehen, in den üblicherweise des Nachts vorherrschenden verbrauchsschwachen Zeiten die von den Grundlastkraftwerken bereitgestellte elektrische Energie aufzunehmen und diese später am Tage, wenn die Wärmeenergie gebraucht wird, wieder abzugeben.

Aufgrund zunehmender Verbreitung alternativer Energien aus Wind- und Solarkraftwerken kann bei einem hohen erzeugten Energieaufkommen diese derzeit nicht sinnvoll genutzt werden und wird daher zum Teil ausgelagert, um diese zu einem späteren Zeitpunkt erneut zu beziehen, was mit entsprechenden Kosten verbunden ist. Auch kann die Abschaltung des auf der Umwandlung regenerativer Energie basierenden Kraftwerks in Erwägung gezogen werden, wodurch an sich erzeugbare Energie jedoch gerade nicht generiert wird. Um alternativ die momentan verfügbare aber aktuell nicht benötigte Energie zwischen zu speichern bedarf es eines Energiespeichers, wie beispielsweise eines Pumpspeicherkraftwerk für große Energiemengen oder einer Nachtspeichers- oder Fußbodenheizung für vergleichsweise geringe Energiemengen. Eine analoge Betrachtung gilt für Kältegeräte, wie z. B. ein Kühlhaus, welches über die erforderliche Minustemperatur hinaus abgesenkt werden kann, um elektrische Energie in Form von Kälte zu speichern, die ansonsten zu einem eventuell netztechnisch betrachtet ungünstigen Zeitpunkt dem Versorgungsnetz entnommen werden muss.

Ohne eine funktionierende Speicherung der elektrischen Energie kommt es zu Instabilitäten im Netz, die in hohem Maße von dem Einsatz regenerativer Energieerzeuger verursacht werden. Hierbei ist zu beachten, dass jede Einspeisung von elektrischer Energie tendenziell spannungsanhebend wirkt, während jede Energieentnahme tendenziell spannungssenkend wirkt. Da die spannungsanhebende Einspeisung schnellen Änderungen unterliegen kann, kann sich auch das Spannungsniveau am zugeordneten Netzverknüpfungspunkt ändern. Bei einer Photovoltaikanlage bewirkt eine lokale Bewölkung beispielsweise z.B. einen Leistungsabfall um 90%, so dass insbesondere bei größeren Windkraftanlagen (Windparks) sowie bei Solaranlagen die Spannung im Versorgungsnetz in Abhängigkeit von den lokalen Wetterbedingungen vor Ort entsprechend schwanken kann.

Um elektrische Verbraucher, beispielsweise Haushaltsgeräte wie Waschmaschinen Waschmaschine, Trockner oder dergleichen zu einem aus Sicht der Energieerzeuger geeigneten Zeitpunkt einzuschalten, ist ein sogenanntes Smartmeter bekannt. In Verbindung mit einem derartigen, z. B. aus der DE 10 2010 027 170 A1 bekannten Smartmeter (Smart-Meter) arbeiten derartige Haushaltsgeräte jedoch im Anschluss an deren Einschaltung unabhängig davon programmgemäß weiter, wie sich die Netzsituation während der Einschaltdauer entwickelt hat.

Gerade bei der alternativen Energieerzeugung kann sich jedoch die Erzeugungssituation innerhalb einer kurzen Zeitspanne, beispielsweise bereits innerhalb einer Minute verändern, was mittels des Smartmeters nicht berücksichtigt wird. Nachteiligerweise sind derartige Smartmeter auch sehr kostenintensiv. Zudem erfordert die Ansteuerung des Smartmeters mittels eines auf die Versorgungspannung aufgeprägten oder separat übermittelten Steuersignals einen hohen Aufwand an Steuer- und Kommunikationstechnologie. Insbesondere die Kommunikationswege verursachen auf Dauer erhebliche Kosten.

Ferner muss ein Smartmeter zur Leistungsaufnahme oder -abgabe angesteuert werden. Die aktuelle Spannungssituation vor Ort bleibt jedoch unbeachtet. So ist nicht auszuschließen, dass das Orts- oder Versorgungsnetz mehr Energie aufnehmen soll, die Smartmeter jedoch zur Energieaufnahme angesteuert werden, obwohl an einer Stelle im Ortsnetz bereits die maximale Last, z.B. durch einen Industriebetrieb, erreicht ist, und eine weitere Leistungsaufnahme durch private Haushalte das Netz hinsichtlich dessen Spannung die Grenzwerte unterschreiten würde. Zusätzlich könnte es an einer anderen Stelle durch die Einspeisung von mittels einer Photovoltaikanlage erzeugter Energie (Solarstrom) erforderlich sein, sehr viel Energie aufzunehmen. Der Smartmeter regelt alle in dem Netz befindliche Verbraucher jedoch pauschal.

Der Erfindung liegt die Aufgabe zugrunde, eine Zähleinrichtung der eingangs genannten Art dahingehend zu verbessern, dass die Nutzung elektrischer Energie in Abhängigkeit der Netzverhältnisse bewertet werden kann. Insbesondere soll dem Nutzer ein Entscheidungskriterium geliefert werden, um vor der Zuschaltung eines Verbrauchers zu erkennen, ob die Zuschaltung zur Stabilisierung oder zur Destabilisierung des Versorgungsnetzes beitragen wird.

Diese Aufgabe wird hinsichtlich der Energieentnahme aus dem Versorgungsnetz erfindungsgemäß gelöst durch die Merkmale des Anspruchs 1 und hinsichtlich der Energieeinspeisung in das Versorgungsnetz durch die Merkmale des Anspruchs 2. Vorteilhafte Ausgestaltungen und Weiterbildungen sind Gegenstand der Unteransprüche.

Die Erfindung geht dabei von der Überlegung aus, dass zusätzlich zur Speicherung elektrischer Energie auch der Verbrauch netzstabilisierend wirken kann, wenn dieser bezüglich der Netzstabilisation zu einem günstigen Zeitpunkt vorgenommen wird.

Erfindungsgemäß ist vorgesehen, in Abhängigkeit von der an der Zähleinrichtung anliegenden Netzspannung deren Betriebsmodus zu verändern. Dabei erfolgt die Veränderung des Betriebsmodus in dem Sinne, dass der Verbrauch bzw. die Einspeisung bei einer höheren anliegenden Netzspannung zu einem langsameren Zählvorgang oder zu einem geringeren Abrechnungsbetrag führt, als der Verbrauch oder die Einspeisung bei einer kleineren Netzspannung. Unter "langsamerer Zählvorgang bzw. geringerer Abrechnungsbetrag" werden alle Vorgänge analoger oder digitaler Art verstanden, die im Ergebnis dazu führen, dass ein über den Wert der herrschenden Spannung modifizierter Zählerbetrieb oder modifizierter Abrechnungsvorgang vorgenommen wird. Die Änderung des Betriebsmodus kann beispielsweise anhand eines entsprechenden zählerinternen Algorithmus erfolgen oder extern, beispielsweise durch Aufprägung eines Steuersignals auf die Netzspannung oder durch drahtlose Signalübertragung, initiiert werden, wozu die Zähleinrichtung entsprechend eingerichtet ist.

Die Veränderung des Betriebsmodus ermöglicht es, je nach Spannungslage im Netz den Verbraucher auf die Folgen der Inbetriebnahme eines Gerätes aufmerksam zu machen. Dabei gilt generell, dass eine hohe Netzspannung auf einen netzseitigen Energieüberschuss hindeutet und eine zu niedrige Netzspannung ein Indiz für einen Energiemangel darstellt. Diese Spannung kann auch bereits in einem Ortsnetz unterschiedlich ausfallen.

Wenn die Zähleinrichtung mit einer Einheit zur Messung der aktuellen Netzspannung und des aktuell fließenden Stroms sowie mit einer Zeiterfassungseinheit ausgerüstet ist, ist es besonders vorteilhaft, die Spannungsmessung zusätzlich zur Bildung der Leistung auch zur Bildung eines Bewertungssignals heranzuziehen, welches unter Berücksichtigung dessen zeitlichen Verlaufs zur Ermittlung einer Abrechnungseinheit beiträgt. Dabei kann der Spannungsverlauf zeitlich integriert und der derart ermittelte Wert als Basis für die Abrechnungseinheit herangezogen werden. Als Zeiterfassung in vorliegendem Sinne werden alle Einrichtungen verstanden, welche entweder selbst takten (clock), durch Kommunikationsmittel die Zeit empfangen oder die Anzahl der Sinuswellen in einem Netz abtasten und zählen.

Über die derart modifizierte Abrechnungseinheit wird somit ein direkter Bezug zu den Energiekosten hergestellt. Für einen Einspeiser elektrischer Energie, wie ein Biogasstromerzeuger oder ein Betreiber einer Kraft-Wärmekopplungsanlage ist häufig die Information wünschenswert, wie werthaltig ein Verbringen seiner Energie in das Netz aktuell ist. Dabei ist das Bewertungssignal derart gestaltet, dass dieses zu einem Verbrauch bei hoher vorliegender Spannung motiviert und demgegenüber eher demotivierend wirkt, ein elektrisches Gerät einzuschalten, wenn die herrschende Spannung niedrig ist. Entsprechendes gilt in gleicher Weise für Energieeinspeiser.

Eine bevorzugte Umsetzung des Bewertungssignals ist, dieses bzw. dessen integralen Wert als Multiplikationsfaktor zur entnommenen (bei Energielieferanten der abgegebenen) elektrischen Leistung einzusetzen und bei vorliegenden Spannungen oberhalb eines oberen Grenzwertes kleiner als 1 zu setzen. Der obere Grenzwert kann bei einer Nennspannung im Versorgungsnetz von 230V z.B. 235 Volt sein. Das heißt, wenn die herrschende Spannung oberhalb von 235V ist, also eine stabile, sichere Versorgungslage vorliegt, wird der Faktor z.B. zu 0,9 gewählt, was einer direkten Abgabenersparnis von 10 % entspricht. Wird demnach eine Energie von beispielweise n kWh abgenommen, so wird lediglich eine Energieabnahme von 0,9 · n kWh berechnet.

Die Reduktion des Bezugspreises kann hierbei lediglich Anwendung auf den seitens des Netzbetreibers zu verantwortenden Teil des Strompreises finden, zumal gesetzliche Abgaben (Steuern, Gebühren etc.) in der Regel stets nach der absoluten abgenommenen elektrischer Energie verrechnet werden. In Deutschland gilt zum Anmeldetag, dass Strom, welcher zur Netzstabilisation nach Anforderung durch den Netzbetreiber gezielt aufgenommen wird, von zumindest einigen gesetzlichen Abgaben befreit ist.

Soll zu einer Abnahme von elektrischer Energie nicht nur motiviert, sondern alternativ oder zusätzlich die Abnahme bei kleinen Spannungen sanktioniert werden, so kann bei einer vorliegenden Spannung unterhalb eines unteren Grenzwertes von z.B. 225V das Bewertungssignal größer als 1 gewählt werden. Wird demgemäß wiederum die Energie von n kWh entnommen, so werden nunmehr 1,1 · n kWh berechnet, weil der Verbrauch zu einem netzdestabilisierenden Zeitpunkt vorgenommen wurde.

Vorteilhafterweise wird das Bewertungssignals als Quotient aus der Nennspannung des Versorgungsnetzes und der aktuell vorliegenden Netzspannung gebildet. Im Ergebnis liegt ein linearer Verlauf vor, der die Abrechnungseinheit proportional zum Spannungsanstieg vermindert bzw. proportional zum Spannungsabfall erhöht. Im Mittelbereich der Nennspannung kann der lineare Bereich durch einen konstanten Bereich ersetzt werden. Innerhalb der in diesem Bereich vorliegenden Spannungswerte bleibt dann die Verrechnungseinheit unverändert.

Eine der Stabilisierung der Netzverhältnisse weitergehend helfende Ausgestaltung sieht vor, dass das Bewertungssignal zumindest in einem Teilbereich von Spannungen unterhalb der Nennspannung überproportional ansteigt. Bei einer niedrigen Netzspannung von z.B. 215 V, die in der Nähe der unteren Grenzspannung von z.B. 210V liegt, sollte ein Verbrauch zu einer derart hohen Abrechnungseinheit führen, dass eine Inbetriebnahme des elektrischen Gerätes wirtschaftlich überdenkenswert ist. Die Überproportionalität kann dabei durch eine logarithmische Funktion, eine Parabelfunktion oder eine trigonometrisch angelehnte Funktion realisiert sein. Liegt die Netzspannung z.B. bei 245V, so ist der Abstand zu einem unstabilen Zustand von mehr als 250V, bei dem ein elektrisches Gerät beschädigt werden könnte, nur noch 5V. Um Verbraucher zu motivieren, das Gerät nun spannungssenkend einzusetzen, kann z.B. die Bewertungseinheit halbiert oder noch weiter reduziert werden. Hier sinkt dann die Bewertungseinheit zumindest in einem Teilbereich von Spannungen oberhalb der Nennspannung überproportional ab.

Als wesentlich wird die Präsenz einer Anzeigevorrichtung angesehen, deren insbesondere optische Anzeige ein Maß für den Wert der Abrechnungseinheit wiederspiegelt. Dabei sollte die Anzeigevorrichtung zumindest zwei der folgenden Parameter zur Anzeige bringt:
i) den aufsummierten gezählten kWh Wert ohne Hinzuziehung des Bewertungssignals,
ii) einen aufsummierten mit Hilfe des Bewertungssignal korrigierten Wert kW(V)h,
iii) einen Verlauf des gebildeten Bewertungssignals,
iv) einen Verlauf der ermittelten Abrechnungseinheit,
v) die Höhe des aktuell vorliegenden Bewertungssignals,
vi) mittels einer Farbgebung ein Maß für die aktuelle Netzunterstützung oder Netzbelastung,
vii) ein Diagramm der Abrechnungseinheit über der Spannung mit Kenntlichmachung des aktuellen Arbeitspunktes,
viii) die Menge der ohne Hinzuziehung des Bewertungssignals aufgelaufenen elektrischen Arbeit, die unter Hinzuziehung des Bewertungssignals korrigierte Menge der aufgelaufenen elektrischen Arbeit und ein Maß für die Differenz zwischen beiden Mengen, und
ix) den prognostizierten geldwerten Nutzen einer aktuell vorzunehmenden Inbetriebnahme eines elektrischen Verbrauchers.

Die Anzeige unter i) entspricht dem derzeit üblichen Vorgehen, das der Nutzer zu jedem Zeitpunkt den bis dahin angefallenen Verbrauch an der Zähleinrichtung ablesen kann. Da nunmehr eine spannungsabhängige Bildung von Abrechnungseinheiten erfolgt, kann auf den Einsatz von Mehrtarifzählern verzichtet werden.

Eine Anzeige des aufsummierten, mit Hilfe des Bewertungssignal korrigierten kW(V)h Wertes ermöglicht eine erste Abschätzung, inwieweit bis zum aktuellen Zeitpunkt eine netzstabilisierende Verbrauchsgestaltung umgesetzt wurde oder nicht. Die Einheit kW(V)h leitet sich dabei aus der Modifikation der erfassten entnommenen elektrischen Energie in kWh mit einem weiteren Spannungseinfluss ab. Wird als Modifikation z.B. der erwähnte Quotient aus Nennspannung zu herrschender Spannung herangezogen, so wird keine physikalische Einheit hinzugefügt. Das in Klammern gesetzte V symbolisiert vielmehr, dass auf den angezeigten Wert gegenüber der klassischen Messung unter Anwendung des Produkts von Spannung U und Strom I unter Berücksichtigung der Netzspannung weitergehend Einfluss genommen wurde.

Die Information über den Verlauf des gebildeten Bewertungssignals oder über den Verlauf der ermittelten Abrechnungseinheit ermöglicht es dem Verbraucher bzw. Nutzer abzuschätzen, ob die aktuelle Abrechnungseinheit in naher Zukunft erhalten bleibt oder nicht. Bei einem wetterbedingt ungünstigen volatilen Verlauf kann sich die Abrechnungseinheit eher ändern, als bei zur regenerativen Energieerzeugung günstigen Wetterbedingungen.

Die Höhe des aktuell vorliegenden Bewertungssignals ist hingegen ein Mittel, um den Verbraucher über die Sinnhaftigkeit einer sofortigen Inbetriebnahme des elektrischen Gerätes zu informieren. Zweckmäßig kann auch eine Farbgebung als Maß für die aktuelle Netzunterstützung oder Netzbelastung sein. Eine vorteilhafte Anzeigeart ist auch eine Diagrammdarstellung der Abrechnungseinheit über der Spannung mit Kenntlichmachung des aktuellen Arbeitspunktes.

Eine bevorzugte Ausführungsform hinsichtlich der Varianten i) bis ix) kann auch die Anzeige der integrierten entnommenen elektrischen Leistung ohne Hinzuziehung des Bewertungssignals und die unter Hinzuziehung des Bewertungssignals korrigierte entnommenen Energie sowie die Differenz zwischen diesen beiden Werten sein. Maß kann dabei ein Balken sein, dessen Dicke oder Länge die Netzunterstützung bzw. -belastung anzeigt, eine farbliche Darstellung derselben, eine direkte Anzeige des geldwerten Nutzens etc.

Weitere noch Ausgestaltungen bestehen darin, dass der Verlauf des Bewertungssignals über die Spannung fest vorgegeben ist, oder mittels eines Rundsteuersignals seitens des Netzbetreibers aus einer vorgegebenen Kurvenschaar eine aktuell anzuwendender Verlauf ausgewählt wird, welcher der Zähleinrichtung als momentan gültig mitgeteilt wird.

Insbesondere auch bei bestehenden elektromechanischen oder elektronischen Zählvorrichtungen kann der Erfindungsgedanke umgesetzt werden, indem der Betriebsmodus in dem Sinne veränderlich ist, dass der Verbrauch bzw. die Einspeisung bei einer höheren anliegenden Netzspannung quasi zu einem langsameren Zählvorgang führt als der Verbrauch bei einer kleineren Netzspannung. Der optimale Nutzen ergibt sich, wenn eine Vielzahl dieser Zähleinrichtungen einge-setzt ist.

Nachfolgen wird ein Ausführungsbeispiel der Erfindung anhand einer Zeichnung näher erläutert. Darin zeigen:
- Fig. 1: eine Zähleinrichtung gemäß der Erfindung;
- Fig. 2: verschiedene Verläufe eines spannungsabhängigen Korrekturfaktors K für die Ermittlung einer modifizierten Abrechnungseinheit; und
- Fig. 3a-3d: Anzeigen unterschiedlicher Informationsvarianten für einen Verbrau-cher.

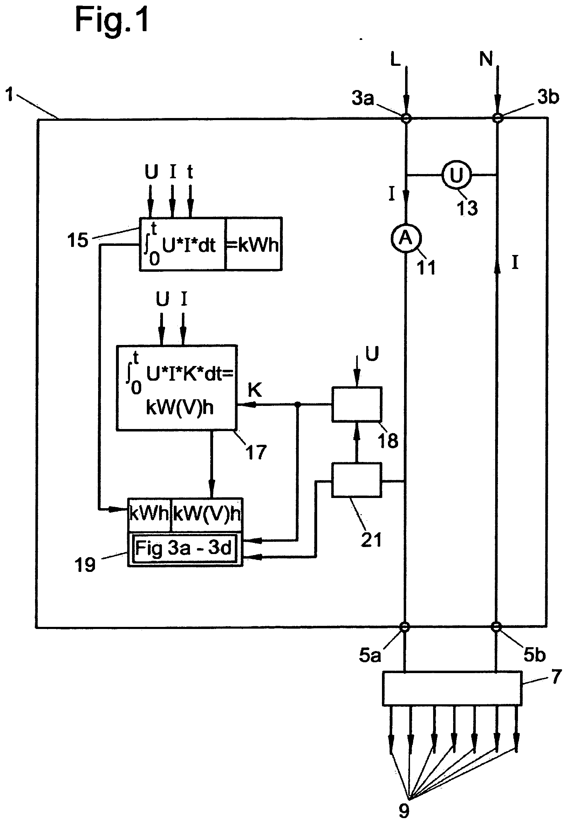

Fig. 1 zeigt schematisch eine Zähleinrichtung 1 für die Abnahme elektrischer Energie mit zwei Eingangsklemmen 3a, 3b und zwei Ausgangsklemmen 5a, 5b. An den Eingangsklemmen 3a, 3b sind ein Leiter L und ein Nullleiter N eines nicht näher dargestellten Versorgungsnetzes angeschlossen, welches von einem Netzbetreiber betrieben wird. An den Ausgangsklemmen 5a, 5b der Zähleinrichtung 1 ist ein Hausverteiler 7 angeschlossen, von welchem wiederum zahlreiche Stromleitungen 9 zu diversen Räumen im Gebäude führen können. Die Zähleinrichtung 1 ist der Übersichtlichkeit halber lediglich in Verbindung mit einer Phase L gezeigt. Jedoch kann die Zähleinrichtung 1 auch an mehrere der verfügbaren Phasen (L1, L2, L3) angeschlossen sein. Zur spannungsabhängigen Messung kann jede Phase einzeln oder auch ein Spannungsmischwert herangezogen werden, der aus den Spannungen U der einzelnen Phasen gebildet wird.

Die Zähleinrichtung 1 umfasst in an sich bekannter Weise ein Strommessgerät 11 und ein Spannungsmessgerät 13. Die gemessenen Werte für den Strom I und die Spannung U werden mit einem Zeitsignal t einem Integrator 15 zugeführt, der aus diesen Werten das Integral des Produktes aus Strom I und Spannung U über die Zeit bildet. Ergebnis ist ein Wert der elektrischen Wirkenergie bzw. der elektrischen Arbeit in der üblichen Abrechnungseinheit kWh, die ohne Anwendung der vorliegenden Erfindung bisher über einen vorgebbaren Zeitraum vom Netzbetreiber mit einem zuvor festgelegten Abrechnungstarif für die kWh berechnet wird.

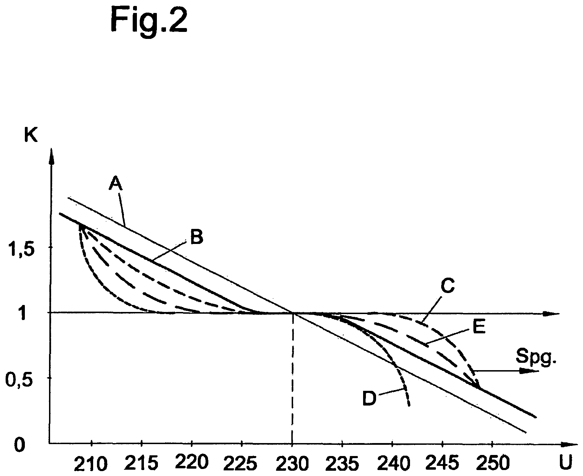

Die Zähleinrichtung 1 weist ein Rechenglied 17 auf, dem als Eingangssignale die Spannung U, der Strom I und ein Korrekturfaktor K zugeführt sind, dessen spannungsabhängiger Verlauf optional vom Netzbetreiber auf eine der Versorgungsleitungen L, N aufmoduliert oder drahtlos, beispielsweise per Funk übertragen wird. Dies ist in Fig. 1 durch eine Linie kenntlich gemacht, die zwischen einem Korrekturfaktorbildner 18 und einem an einen Leiter L des Netzes angeschlossen Empfangsteil 21 eingezeichnet ist. Der Korrekturfaktor K kann auch lediglich aus der aktuell vorliegenden Spannung U gebildet werden, ohne dass es eine aktuelle Unterstützung seitens des Netzbetreibers bedarf. Die Gestaltung des Korrekturfaktors K ist spannungsabhängig und wird später anhand der Fig. 2 näher erläutert.

Das Rechenglied 17 beinhaltet ein Integrierglied, welches das Produkt aus Spannung U, Strom I und Korrekturfaktor K über die Zeit t integriert. Das Ergebnis ist die Bildung einer fiktiven Abrechnungseinheit kW(V)h, wobei das in Klammern gesetzte V darauf hinweisen soll, dass die fiktive Abrechnungseinheit kW(V)h mittels eines spannungsabhängigen Korrekturfaktors K modifiziert ist. Der Korrekturfaktor K und/oder dessen Verlauf über die Spannung U kann fest vorgegeben sein oder über den Korrekturfaktorbildner 18, sofern dieser an das später beschriebene Empfangsteil 21 angeschlossen ist, aus dem oben angesprochenen aufmodulierten Signal gebildet werden. Letzteres erlaubt es dem Netzbetreiber, den Korrekturfaktor K für eine aktuelle Netzsituation speziell auszubilden.

Die entnommene Energie in kWh und die mittels des Korrekturfaktors K gebildete fiktive Abrechnungseinheit kW(V)h wird auf einem Display 19 zur Anzeige gebracht. Das gezeigte Display 19 ist beispielhaft mit drei Feldern gezeigt, von denen ein Feld für die Anzeige der entnommene Energie in kWh, ein zweites Feld für die Anzeige der aufgelaufenen Abrechnungseinheiten in kW(V)h und das dritte Feld für die Anzeige einer Entscheidungshilfe dient, ob eine anstehende Inbetriebnahme eines elektrischen Gerätes zum aktuellen Zeitpunkt netzunterstützend oder netzbelastend wirkt.

Das Display 19 ist vorzugsweise zusätzlich an das Empfangsteil 21 angeschlossen, in welchem ein auf eine der Versorgungsleitungen L, N aufmoduliertes Signal des Netzbetreibers dekodiert werden kann. Die von dem Empfangsteil 21 empfangenen Signale betreffen Informationen zur Tarifgestaltung des Netzbetreibers bei der aktuell vorliegenden Versorgungssituation. Diese Information kann insbesondere in Verbindung mit dem aktuell anliegenden Korrekturfaktor K die Ersparnis oder die finanzielle Mehrbelastung einer Inbetriebnahme eines elektrischen Gerätes dem Nutzer veranschaulichen. Die Ersparnis oder Zusatzbelastung, beispielsweise in Cent, für den unmittelbaren, zukünftigen Verbrauch wird normiert auf die anfallende Energie in kWh angezeigt. Diese Entscheidungshilfe für den Verbraucher, ob das Gerät jetzt oder später eingeschaltet werden sollte, ist prinzipiell auch alleine aus dem Wert des anstehenden Korrekturfaktors K herleitbar.

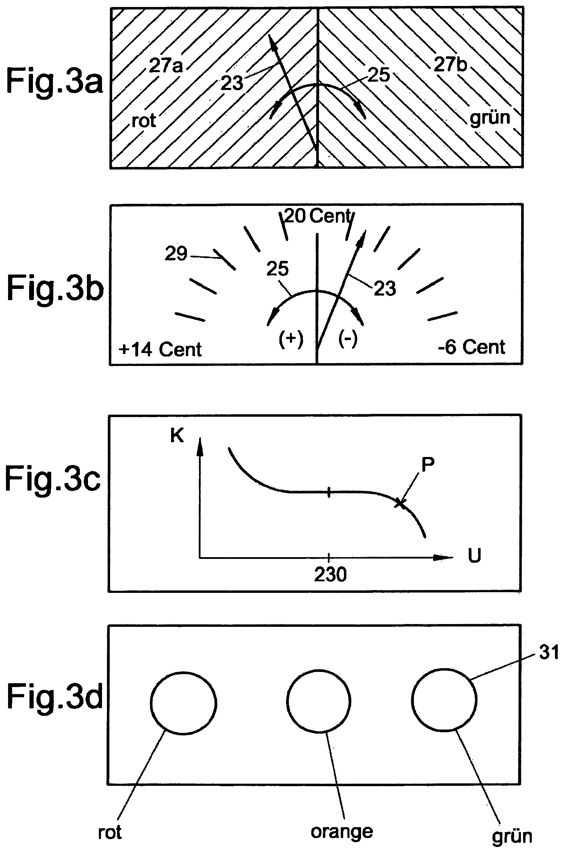

Die über das Empfangsteil 21 empfangenen Informationen ermöglichen weitere aktuelle Besonderheiten im Tarif, die nicht von der herrschenden Spannung U abhängen oder nicht von den Verläufen des Korrekturfaktors K gemäß Fig. 3 erfasst sind. So kann z.B. ein Nutzer, der 100% Ökostrom kauft, über eine extrem hohe Abrechnungseinheit kW(V)h bzw. einen entsprechend hohen Abrechnungstarif dahingehend motiviert werden, von einem zusätzlichen Energieverbrauch abzusehen, weil aktuell kein ausreichender Anteil an Ökostrom an der Strombörse gehandelt wird. Analog kann der Nutzer zu einem Verbrauch motiviert werden, wenn Ökostrom im Überfluss verfügbar ist.

Einem aufmerksamen Verbraucher erschließt sich die Möglichkeit, zu einem Kompensationsmechanismus für Spannungsausschläge im Versorgungsnetz nach oben und unten beizutragen, indem er Maßnahmen zum Abbau von in Heiz- oder Kühlgeräten bevorrateter Energie ergreift oder Energie einspeichert, je nach dem, ob die herrschende Spannung hoch (Energie einlagern) oder niedrig ist (bevorratete Energie aufbrauchen). Die aktuellen Kosten können dabei eine entsprechende Motivation sein.

Ist im Winter z.B. die Spannung hoch, weil mehr Energie aus Wind und Sonne in das Netz eingespeist wird, als momentan abgenommen wird, so kann die Abrechnungseinheit in kW(V)h derart günstig angesetzt werden, dass der Verbraucher Räume mit kostengünstigem Strom heizt, um die elektrische Heizung zu einem späteren Tageszeitpunkt mit kostenintensivem Strombezug auszusetzen. Auch ist es zweckmäßig den Zuschaltvorgang dahingehend zu automatisieren, dass die Geräte die Spannung selbstständig messen und entsprechend dem gemessenen Spannungsniveau selbsttätig zu- oder abzuschalten. Die Zuschaltentscheidung kann dabei eine Vorratsspeicherung zur Netzstabilisierung berücksichtigen, sofern die verwendeten Geräte dazu geeignet sind, wie beispielsweise eine Tiefkühlgerät oder eine Speicherheizung.

In Fig. 2 sind mögliche Verläufe des Korrekturfaktors K über die Spannung U aufgetragen. Die Kurve A stellt eine Gerade dar, die durch den vom Wertepaar K = 1 und U = 230V gebildeten Punkt als Nennspannung verläuft. Die Steigung der Geraden entspricht dem Quotienten U/U_{Nenn} aus der gemessenen Spannung U und der Nennspannung U_{Nenn} multipliziert mit einem Faktor für die gewünschte Varianz in der Tarifbildung, also ob eine moderate Ersparnis bei hohen Spannungen einhergehend mit einer moderaten Kostenerhöhung bei kleinen Spannungen U gewünscht ist.

Die Kurve B weist im Bereich zwischen 225V und 235V einen linearen Bereich auf, in dem keine Änderung des Korrekturfaktors K vorgenommen wird. K = 1 entspricht einer kWh einer Abrechnungseinheit kW(V)h. Bei einer Spannung U kleiner als 225V wird der Strombezug entsprechend dem gezeigten linearen Verlauf kostenintensiver, weil sich der Korrekturfaktor K zu Werten größer 1 verschiebt. Bei einer Spannung U größer als 235V wird der Strombezug entsprechend dem gezeigten linearen Verlauf preiswerter, weil sich der Korrekturfaktor K zu Werten kleiner 1 verschiebt. Die Steigungen können gleich oder - je nach Strategie der Netzbetreiber - unterschiedlich gewählt werden, d. h. es können netzunterstützende Maßnahmen gegenüber netzbelastenden Maßnahmen mit entsprechend niedrigen oder hohen Abrechnungstarifen einhergehen.

Die Kurven C, D und E sind mögliche Beispiele für weitere Varianten des Verlaufs des Korrekturfaktors K. Im Empfangsteil 21 kann eine beliebige Kurvenschaar vorprogrammiert sein, aus der der Netzbetreiber eine aktuell bevorzugte Kurve per Rundsteuersignal oder drahtlos auswählen kann. Das Empfangsteil 21 kann auch nicht vorprogrammierte Kurven empfangen und der Kurvenschaar hinzufügen. Den Kurven gemeinsam ist eine relativ steile Abnahme des Korrekturfaktors K zu höheren Spannungen U hin, was zu einer kleineren Abrechnungseinheit kW(V)h führt, und eine relativ steile Zunahme des Korrekturfaktors K zu kleineren Spannungen U hin, was zu höheren Abrechnungseinheiten kW(V)h führt.

In den Fig. 3a bis 3d sind beispielhafte Darstellungen gezeigt, die für den Verbraucher als Entscheidungshilfe hinsichtlich des Zeitpunktes der Inbetriebnahme eines elektrischen Gerätes dienen können. Fig. 3a zeigt als Entscheidungshilfe einen Zeiger 23, der in Richtung eines Doppelpfeils 25 seine Position innerhalb eines rot unterlegten Bereichs 27a und eines grün unterlegten Bereichs 27b verändern kann. Eine Veränderung erfolgt im Hinblick auf die aktuell vorliegende Spannung U. Dabei signalisiert eine Stellung des Zeigers 23 im grünen Bereich 27b, dass die sofortige Inbetriebnahme des elektrischen Gerätes netzunterstützend wirkt. Befindet sich der Zeiger 23 hingegen im roten Bereich 27a, wäre die sofortige Inbetriebnahme netzbelastend.

In Fig. 3b ist eine analoge Zeigerdarstellung gezeigt, wobei anstelle der farblich gekennzeichneten Bereiche 27a, 27b eine Skala 29 vorgesehen ist, die den direkten Wert der Abrechnungseinheit kW(V)h in Cent angibt. Der Zeiger 23 steht dann auf dem aktuellen Tarifwert für eine kWh, wenn das Gerät in Betrieb genommen wird. Die Skala 29 kann auch derart aufgebaut sein, dass die Ersparnis oder die Aufzahlung bezüglich des Normtarifes kenntlich gemacht wird. In Fig. 3b wären dies null Cent (0 ct) in der Mittelstellung des Zeigers 23 - anstelle des Tarifpreises von zwanzig Cent (20 ct) - und plus vierzehn Cent (14 ct) bei einer Zeigerstellung am linken Ende der Skala 29 sowie minus sechs Cent (6 ct) bei einer Zeigerstellung am rechten Anschlag. Die Darstellung kann anstelle des Zeigers 23 auch mit Dezimalziffern oder dergleichen erfolgen.

Fig. 3c zeigt ein Beispiel für den dritten Abschnitt des Displays 19, bei dem die aktuell gültige Kurve, z.B. ein Kurvenverlauf entsprechend Fig. 2, für den Korrekturfaktor K über die Spannung U dargestellt ist. Kenntlich ist der aktuelle Arbeitspunkt P = U(K,t) entlang der Kurve. Anstelle des Korrekturfaktors K kann auch ein Cent-Wert für die Abrechnungseinheit kW(V)h auf der Ordinatenachse abgetragen sein.

Fig. 3d zeigt ein Display mit drei Leuchtkörpern 31 in den Farben rot, gelb und grün, um dem Verbraucher ein Zurückstellen (rot), die Aufnahme bei aktuell erforderlichem Bedarf (gelb) oder die sofortige Einleitung zusätzlicher Energieentnahme (grün) aus dem Netz anzuzeigen.

Folgende weitere Ausgestaltungen sind für sich alleine gesehen und/oder in Verbindung mit anderen in den Ansprüchen niedergelegten Merkmalen bevorzugt:
i) Bei mehreren, unterschiedlichen Netzspannungswerten oder -bereichen zugeordneten Tarifkategorien wird in einer bestimmten Tarifkategorie gezählt;
ii) Es sind mindestens drei Tarifkategorien vorhanden, wobei eine Zählung in der ersten Kategorie aktiviert ist, wenn die Netzspannung U einen unteren Grenzwert unterschreitet, wobei die Zählung in der dritten Kategorie aktiviert ist, wenn die Netzspannung U einen oberen Grenzwert unterschreitet, und wobei die Zählung in der zweiten Kategorie aktiviert ist, wenn die Netzspannung U im Bereich zwischen dem unteren und dem oberen Grenzwert liegt;
iii) die aktuelle Tarifkategorie wird angezeigt.

Die veränderliche Abrechnungseinheit kW(V)h ist sowohl verbraucherseitig bei der Energieentnahme als auch erzeugerseitig bei der Energieeinspeisung nützlich. Erfolgt die Energieeinspeisung aufgrund regenerativer Energieerzeugung, so wird der Energieerzeuger bestrebt sein, unabhängig von der herrschenden Spannung U stets in das Netz einzuspeisen. Im Zusammenhang mit Biogas, Wasser und Kraftwärmekopplungsanlagen sollte die Umsetzung gespeicherter Energie ökonomisch und netzstabilisierend ablaufen. Hierbei eignet sich die Erfindung zur Netzstabilisierung durch Integration regenerativ erzeugter Wind- und Sonnenenergie, um einen kostenintensiven Netzausbau zu vermeiden.

### Bezugszeichenliste

- 1: Zähleinrichtung
- 3a,3b: Eingangsklemmen
- 5a,5b: Ausgangsklemmen
- 7: Hausverteiler
- 9: Stromleitungen
- 11: Strommessgerät
- 13: Spannungsmessgerät
- 15: Integrator
- 17: Rechenglied
- 18: Korrekturfaktorbildner
- 19: Display
- 21: Empfangsteil
- 23: Zeiger
- 25: Doppelpfeil
- 27a,27b: farblicher Bereich
- 29: Skala

- L,N: Leiter
- U: Spannung
- I: Strom
- t: Zeit
- K: Korrekturfaktor
- P: Arbeitspunkt

## Patentansprüche

1. Zähleinrichtung (1) zur Erfassung der einem elektrischen Versorgungsnetz (L, N) entnommenen elektrischen Energie (kWh), mit Mitteln (13) zur Messung der aktuellen Netzspannung (U), und mit Mitteln (15, 17) zur Bestimmung des Betriebsmodus der Zähleinrichtung, wobei der Betriebsmodus in Abhängigkeit von der gemessenen Netzspannung (U) derart veränderbar ist, dass eine vergleichsweise hohe Netzspannung (U) einen langsameren Zählvorgang bewirkt als eine vergleichsweise niedrige Netzspannung (U).

2. Zähleinrichtung (1) zur Bestimmung der an ein elektrisches Versorgungsnetz (L, N) abgegebenen elektrischen Energie (kWh), mit Mitteln (13) zur Messung der Netzspannung (U) an einem Netzspannungsanschluss (5a, 5b), und mit Mitteln (15, 17) zur Bestimmung des Betriebsmodus der Zähleinrichtung, wobei der Betriebsmodus in Abhängigkeit von der gemessenen Netzspannung (U) derart veränderbar ist, dass eine vergleichsweise hohe Netzspannung (U) einen langsameren Zählvorgang bewirkt als eine vergleichsweise niedrige Netzspannung (U).

3. Zähleinrichtung (1) nach Anspruch 1 oder 2, wobei der Betriebsmodus bei der vergleichsweise hohen Netzspannung (U) zu einem geringeren Abrechnungsbetrag führt als bei der vergleichsweise niedrigen Netzspannung (U).

4. Zähleinrichtung (1) nach Anspruch 1 oder 2, wobei anhand der gemessenen Netzspannung (U) ein Bewertungssignal (K) gebildet ist, welches unter Berücksichtigung dessen zeitlichen Verlauf zur Ermittlung einer Abrechnungseinheit (kW(V)h) herangezogen wird.

5. Zähleinrichtung (1) nach Anspruch 3, wobei das Bewertungssignal (K) kleiner als 1 ist, wenn die gemessene Netzspannung (U) größer ist als ein oberer Grenzwert, und wobei das Bewertungssignal (K) größer als 1 ist, wenn die gemessene Netzspannung (U) kleiner als ein unterer Grenzwert ist.

6. Zähleinrichtung (1) nach einem der Ansprüche 3 oder 4, wobei das Bewertungssignal (K) dem Quotient aus der Nennspannung (U_{Nenn}) des Versorgungsnetzes und der gemessenen Spannung (U) ist.

7. Zähleinrichtung (1) nach einem der Ansprüche 3 bis 5, wobei das Bewertungssignal (K) überproportional ansteigt, wenn die gemessene Netzspannung (U) kleiner ist als die Nennspannung (U_{Nenn}), und wobei das Bewertungssignal (K) überproportional absinkt, wenn die gemessene Netzspannung (U) größer ist als die Nennspannung (U_{Nenn}).

8. Zähleinrichtung (1) nach einem der Ansprüche 1 bis 6, mit einer Anzeigevorrichtung (19) zur Anzeige des netzspannungsabhängigen Wertes einer Abrechnungseinheit.

9. Zähleinrichtung (1) nach Anspruch 8, wobei die Anzeigevorrichtung (19) zur Anzeige von mindestens zwei der folgenden Parameter eingerichtet ist:
- die gezählte Energie (kWh),
- einen aufsummierten Betrag der mittels des Bewertungssignals (K) gewichteten Abrechnungseinheit (kW(V)h)
- den Verlauf des gebildeten Bewertungssignals (K),
- den Verlauf der ermittelten Abrechnungseinheit (kW(V)h),
- den Betrag des aktuellen Bewertungssignals (K),
- mittels Farbgebung das Maß einer aktuellen Netzunterstützung oder Netzbelastung,
- in Diagrammdarstellung die spannungsabhängige Abrechnungseinheit (kW(V)h) oder das spannungsabhängige Bewertungssignals (K) mit Kenntlichmachung des aktuellen Arbeitspunktes (P),
- die Menge der elektrischen Energie (kWh) ohne Hinzuziehung des Bewertungssignals (K), die mittels des Bewertungssignals (K) gewichtete Menge der elektrischen Energie (kW(V)h) sowie die Differenz zwischen beider Mengen, und
- den prognostizierten Nutzen einer aktuell vorzunehmenden Inbetriebnahme eines elektrischen Verbrauchers.

10. Zähleinrichtung (1) nach einem der Ansprüche 3 bis 8, wobei der spannungsabhängige Verlauf des Bewertungssignals (k) einrichtungsintern vorgegeben oder netzseitig aus einer einrichtungsintern hinterlegten Kurvenschaar ausgewählt ist.

## Claims

1. Meter (1) for recording the electrical energy (kWh) taken from an electrical supply network (L, N), having means (13) for measuring the current network voltage (U) and having means (15, 17) for determining the operating mode of the meter, wherein the operating mode can be changed on the basis of the measured network voltage (U) in such a manner that a comparatively high network voltage (U) causes a slower metering operation than a comparatively low network voltage (U).

2. Meter (1) for determining the electrical energy (kWh) delivered to an electrical supply network (L, N), having means (13) for measuring the network voltage (U) at a network voltage connection (5a, 5b) and having means (15, 17) for determining the operating mode of the meter, wherein the operating mode can be changed on the basis of the measured network voltage (U) in such a manner that a comparatively high network voltage (U) causes a slower metering operation than a comparatively low network voltage (U).

3. Meter (1) according to Claim 1 or 2, wherein the operating mode for the comparatively high network voltage (U) results in a lower billing amount than for the comparatively low network voltage (U).

4. Meter (1) according to Claim 1 or 2, wherein an assessment signal (K) is formed on the basis of the measured network voltage (U) and is used to determine a billing unit (kW(V)h) taking into account its temporal profile.

5. Meter (1) according to Claim 3, wherein the assessment signal (K) is less than 1 if the measured network voltage (U) is greater than an upper limit value, and wherein the assessment signal (K) is greater than 1 if the measured network voltage (U) is less than a lower limit value.

6. Meter (1) according to either of Claims 3 and 4, wherein the assessment signal (K) is the quotient of the nominal voltage (U_{Nenn}) of the supply network and the measured voltage (U).

7. Meter (1) according to one of Claims 3 to 5, wherein the assessment signal (K) increases disproportionately if the measured network voltage (U) is less than the nominal voltage (U_{Nenn}), and wherein the assessment signal (K) falls disproportionately if the measured network voltage (U) is greater than the nominal voltage (U_{Nenn})

8. Meter (1) according to one of Claims 1 to 6, having a display apparatus (19) for displaying the network-voltage-dependent value of a billing unit.

9. Meter (1) according to Claim 8, wherein the display apparatus (19) is set up to display at least two of the following parameters:
- the metered energy (kWh),
- a summed amount of the billing unit (kW(V)h) weighted by means of the assessment signal (K),
- the profile of the assessment signal (K) formed,
- the profile of the billing unit (kW(V)h) determined,
- the absolute value of the current assessment signal (K),
- the level of current network support or a current network load by means of colouring,
- the voltage-dependent billing unit (kW(V)h) or the voltage-dependent assessment signal (K) in a diagram representation with an indication of the current operating point (P),
- the amount of electrical energy (kWh) without using the assessment signal (K), the amount of electrical energy (kW(V)h) weighted by means of the assessment signal (K) and the difference between the two amounts, and
- the predicted benefit of activation of an electrical load to be currently carried out.

10. Meter (1) according to one of Claims 3 to 8, wherein the voltage-dependent profile of the assessment signal (K) is predefined inside the meter or is selected in the network from a family of curves stored inside the meter.

## Revendications

1. Dispositif de comptage (1), destiné à détecter l'énergie électrique (kWh) prélevée sur un réseau d'alimentation électrique (L, N), doté de moyens (13) pour mesurer la tension réseau actuelle (U) et de moyens (15, 17) pour déterminer le mode de fonctionnement du dispositif de comptage, le mode de fonctionnement étant variable en fonction de la tension réseau (U) mesurée, de telle sorte qu'une tension réseau (U) comparativement élevée provoque un processus de comptage plus lent qu'une tension réseau (U) comparativement faible.

2. Dispositif de comptage (1), destiné à détecter l'énergie électrique (kWh) prélevée sur un réseau d'alimentation électrique (L, N), doté de moyens (13) pour mesurer la tension réseau actuelle (U)sur un branchement sur la tension réseau (5a, 5b) et de moyens (15, 17) pour déterminer le mode de fonctionnement du dispositif de comptage, le mode de fonctionnement étant variable en fonction de la tension réseau (U) mesurée, de telle sorte qu'une tension réseau (U) comparativement élevée provoque un processus de comptage plus lent qu'une tension réseau (U) comparativement faible.

3. Dispositif de comptage (1) selon la revendication 1 ou 2, sous la tension réseau (U) comparativement élevée, le mode de fonctionnement menant à un montant facturé plus faible que sous la tension réseau (U) comparativement faible.

4. Dispositif de comptage (1) selon la revendication 1 ou 2, à l'aide de la tension réseau (U) mesurée, un signal d'évaluation (K) étant créé, lequel sous considération de sa courbe dans le temps est impliqué pour déterminer une unité de facturation (kW(V)h).

5. Dispositif de comptage (1) selon la revendication 3, le signal d'évaluation (K) étant inférieur à 1 si la tension réseau (U) mesurée est supérieure à une valeur limite supérieure et le signal d'évaluation (K) étant supérieur à 1 si la tension réseau (U) mesurée est inférieure à une valeur limite inférieure.

6. Dispositif de comptage (1) selon l'une quelconque des revendications 3 ou 4, le signal d'évaluation (K) étant le quotient de la tension nominale (U_{Nenn}) du réseau d'alimentation et de la tension mesurée (U) .

7. Dispositif de comptage (1) selon l'une quelconque des revendications 3 à 5, le signal d'évaluation (U) croissant de manière disproportionnée si la tension réseau (U) mesurée est inférieure à la tension nominale (U_{Nenn}) et le signal d'évaluation (K) décroissant de manière disproportionnée si la tension réseau (U) mesurée est supérieure à la tension nominale (U_{Nenn}).

8. Dispositif de comptage (1) selon l'une quelconque des revendications 1 à 6, doté d'un dispositif d'affichage (19) destiné à afficher la valeur dépendant de la tension réseau d'une unité de facturation.

9. Dispositif de comptage (1) selon la revendication 8, le dispositif d'affichage (19) étant aménagé pour afficher au moins l'un des paramètres suivants :
- l'énergie (kWh) comptée,
- un montant totalisé de l'unité de facturation (kW(V)h) pondérée au moyen du signal d'évaluation (K),
- la courbe du signal d'évaluation (K) créé,
- la courbe de l'unité de facturation (kW(V)h) déterminée,
- la valeur du signal d'évaluation (K) actuel,
- au moyen d'une coloration, la dimension d'une assistance réseau ou charge réseau actuelle,
- représentée dans un diagramme, l'unité de facturation (kW(V)h) dépendant de la tension ou le signal d'évaluation (K) dépendant de la tension, avec indication du point de travail actuel (P),
- la quantité de l'énergie électrique (kWh) sans implication du signal d'évaluation (K), la quantité de l'énergie électrique (kW(V)h) pondérée au moyen du signal d'évaluation (K), ainsi que la différence entre les deux quantités et
- l'utilité pronostiquée d'une mise en service d'un consommateur électrique à laquelle il doit être actuellement procédé.

10. Dispositif de comptage (1) selon l'une quelconque des revendications 3 à 8, la courbe dépendant de la tension du signal d'évaluation (k) étant prédéfinie en interne au système ou étant choisie côté réseau, dans une famille de courbes sauvegardée en interne au système.
